(19) Europäisches Patentamt
European Patent Office
Office européen des brevets

(11) **EP 4 660 640 A1**

(12) **EUROPEAN PATENT APPLICATION**

(43) Date of publication:
**10.12.2025 Bulletin 2025/50**

(21) Application number: **25166418.1**

(22) Date of filing: **26.03.2025**

(51) International Patent Classification (IPC):
**G01R 29/08** (2006.01)

(52) Cooperative Patent Classification (CPC):
**G01R 29/0842**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **06.06.2024 US 202418735917**

(71) Applicant: **The Boeing Company**
**Arlington, VA 22202 (US)**

(72) Inventors:
• **Tuck, Derek R.**
**Arlington, 22202 (US)**
• **Egenriether, Brian**
**Arlington, 22202 (US)**
• **Chandra, Nitish**
**Arlington, 22202 (US)**
• **Hwang, Kyu-Pyung**
**Arlington, 22202 (US)**

(74) Representative: **Witte, Weller & Partner**
**Patentanwälte mbB**
**Postfach 10 54 62**
**70047 Stuttgart (DE)**

(54) **PRECIPITATION STATIC AIRCRAFT MODEL FOR ANTENNA INTERFERENCE**

(57)     A method (300) is presented for evaluating precipitation static (p-static) radiofrequency interference (270). The method (300) comprises receiving (310) an aircraft surface model (205) and generating (320) a p-static charging model (220) for the aircraft surface model (205). A charge state of the p-static charging model (220) is adjusted (330) based on a charge dissipation model (230). An emitted power spectra (250) from the aircraft surface model (205) is determined (340) based on the adjusted charge state. Electrostatic emissions coupling to an antenna (610, 612) are determined (350) based on the emitted power spectra (250). A level of p-static radiofrequency interference (270) is indicated (360) based on the electrostatic emissions coupling to the antenna (610, 612).

300

310
RECEIVE AN AIRCRAFT SURFACE MODEL

320
GENERATE A P-STATIC CHARGING MODEL FOR THE AIRCRAFT SURFACE MODEL

330
ADJUST A CHARGE STATE OF THE P-STATIC CHARGING MODEL BASED ON A CHARGE DISSIPATION MODEL

340
DETERMINE AN EMITTED POWER SPECTRA FROM THE AIRCRAFT SURFACE MODEL BASED ON THE ADJUSTED CHARGE STATE

350
DETERMINE ELECTROSTATIC EMISSIONS COUPLING TO AN ANTENNA BASED ON THE EMITTED POWER SPECTRA

360
INDICATE A LEVEL OF P-STATIC RADIOFREQUENCY INTERFERENCE BASED ON THE ELECTROSTATIC EMISSIONS FROM THE AIRCRAFT SURFACE COUPLING TO THE ANTENNA

FIG. 3

**Description**

FIELD

The present disclosure relates generally to charging of an aircraft surface, and, in particular, to modeling radiofrequency interference of an aircraft based on precipitation static charging and discharging.

BACKGROUND

Precipitation static or p-static describes electrostatic charging of aircraft surfaces due to collision with dust, ice crystals, rain, sand, smoke, snow and other particles during flight. Impingement of these particles transfers charge at the point of impact on the aircraft exterior surface, which results in an electrostatic charge accumulation on the aircraft. Charge build-up causes interference with aircraft navigation and communication systems by broadband discharges such as corona from sharp extremities, streamering from dielectric surfaces, and sparking or arcing from unbonded metal objects.

The potential for p-static interference on communication and navigation systems is dependent on the charging environment and the discharge location, magnitude, and frequency of radiofrequency emissions. Excessive build-up of p-static in high charging areas nearby antennas thus has the potential of generating RF emissions that could affect communication and navigation performance in certain settings and/or under certain conditions, such as during a period of inclement weather. To test for aircraft performance in p-static environments, an aircraft may be flown through severe charging conditions wherein normal radio operation is verified. This testing procedure adds lead time to the certification of the aircraft. This verification is also subjective as it requires the flight test pilot to determine if the level of radio interference is acceptable. The testing procedure also limits the ability of designer to optimize aircraft designs for precipitation static issues. Few prior solutions for modeling p-static phenomena exist. The prior solutions for modeling p-static phenomena that do exist focus on limited aspects of the p-static problem.

SUMMARY

According to the present disclosure, a method for evaluating precipitation static (p-static) radiofrequency interference, a computing system for evaluating precipitation static (p-static) radiofrequency interference, and a method for evaluating precipitation static (p-static) radiofrequency interference, as defined in the independent claims, are provided. Further embodiments are defined in the dependent claims. Although the scope is only defined by the claims, the below embodiments, examples, and aspects are present for aiding in understanding the background and advantages. A method is presented for evaluating precipitation static (p-static) radiofrequency interference. The method comprises receiving an aircraft surface model and generating a p-static charging model for the aircraft surface model. A charge state of the p-static charging model is adjusted based on a charge dissipation model. An emitted power spectrum from the aircraft surface model is determined based on the adjusted charge state. Electrostatic emissions coupling to an antenna are determined based on the emitted power spectra. A level of p-static radiofrequency interference is indicated based on the electrostatic emissions coupling to the antenna.

This Summary is provided in order to introduce in simplified form a selection of concepts that are further described in the Detailed Description. This Summary is not intended to identify key features or essential features of the claimed subject matter, nor is it intended to be used to limit the scope of the claimed subject matter. The claimed subject matter is not limited to implementations that solve any disadvantages noted in any part of this disclosure.

BRIEF DESCRIPTION OF THE DRAWINGS

FIG. 1 shows an example aircraft flying through suspended atmospheric particles.
FIG. 2 schematically shows a modeling system for evaluating p-static radiofrequency interference.
FIG. 3 shows a flow diagram for an example method for evaluating p-static radiofrequency interference.
FIGS. 4A-4B show current density on an aircraft surface.
FIG. 5 shows an example plot of aircraft potential and discharge current for an aircraft surface over time.
FIG. 6 shows an example of arc emissions from an aircraft surface.
FIG. 7A shows an example plot of total radiated power from a discharge model in the time domain.
FIG. 7B shows an example plot of total radiated power transformed into the frequency domain.
FIG. 8 shows an example model of a high frequency antenna.
FIG. 9A shows surface current density for a model fuselage at 10 MHz.
FIG. 9B shows surface current density for a model fuselage at 100 MHz.

FIG. 10 schematically shows aspects of an example computing system.

DETAILED DESCRIPTION

During flight, an aircraft is first charged through triboelectric charging, charged particle impact, or the ambient electric field. This charge is then conducted or dissipated throughout the aircraft. Corona discharge and p-static wicking allows some charge to leave the aircraft. If not properly dissipated, this charge can accumulate on different locations and create dielectric breakdown, resulting in high localized currents and electric fields. If the residual charge creates a voltage that exceeds a breakdown threshold, dielectric breakdown occurs, creating a localized current surge. These current surges, in turn, lead to electromagnetic (EM) emissions that can then couple to antennas and wiring, potentially creating an unacceptable level of p-static interference. Federal Aviation Administration (FAA) regulations govern normal aircraft operation in severe p-static environments when designing aircraft.

General guidance for p-static design includes bonding all exterior conductive surfaces to structure and applying anti-static coatings to nonconductive surfaces and bonding these to structure. As such, of particular interest is the use of unbonded conductive materials (i.e., isolated electrical conductors) on aircraft surfaces. Such conductive materials include foil-based speed tape. Dielectric materials, such as decals may also be adhered to aircraft surfaces. When exposed to triboelectric (e.g., frictional) charging, such as ice particles impinging on aircraft surfaces, electrical charge accumulates on the exposed foil of the speed tape until the voltage between the foil and structure exceeds the standoff capability of the adhesive layer. This charge accumulation causes periodic uncontrolled discharge at the edges of the speed tape. These periodic discharges are radio frequency (RF) sources that propagate RF energy. Such RF energy has the potential to interfere with communication and navigation systems of the aircraft, with the severity of interference dependings on the magnitude and spectra of the RF source received by the system(s) and sensitivity of the system(s).

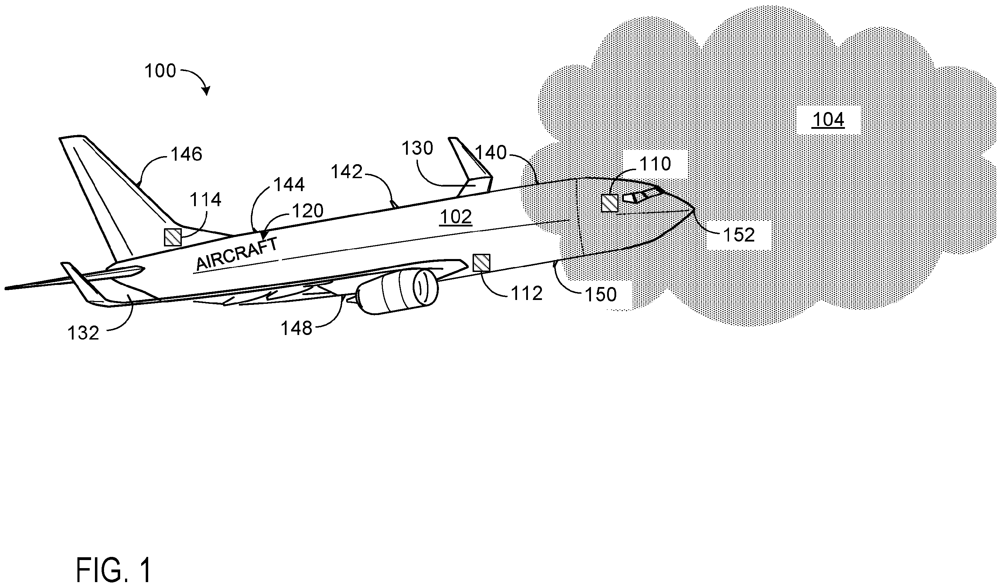

As an example, FIG. 1 depicts an aircraft 100 with an aircraft surface 102. Although primarily described with regards to commercial airliners, "aircraft" as used herein may describe airplanes, non-traditional aircraft, such as fixed wing aircraft and/or vertical take-off and landing aircraft, autonomous and semi-autonomous aircraft, as well as spacecraft, satellites, etc. As shown, Aircraft 100 is flying through suspended atmospheric particles 104. Speed tape patches are shown on aircraft surface 102 at 110, 112, and 114. Such patches are merely illustrative, and there may be more or fewer speed tape patches at various locations on the aircraft surface. A decal 120 is also positioned on aircraft surface 102. Static dischargers 130 and 132 are also positioned on aircraft surface 102.

Antennas of the same, several or numerous types may be positioned around aircraft surface 102 on the wings, fuselage, tail, fins, nose, etc. Examples are shown at 140, 142, 144, 146, 148, 150, and 152. Antenna types can include communications antennas, global positioning system (GPS) antennas, long-range (Loran) navigation antennas, loop antennas, marker beacon antennas, nav antennas, radio altimeters, ultra-high frequency (UHF) antennas, etc. P-static interference may inhibit communication with loran antennas, high Frequency (HF) and very high frequency (VHF) antennas and create risk with navigation using antennas like Automatic Direction Finder (ADF) and Very High frequency Omnidirectional Range Station (VOR).

A physics-based model is presented herein that may be used to predict p-static charging, dissipation, and interference for new aircraft design configurations and unbonded conductor applications. The modeling may be used to develop material and material application guidelines for compliance to p-static interference mitigation and discover new design solutions. The physics-based model comprises a suite of simulation tools that, when applied together, capture the physics leading to p-static interference. The output of the model estimates p-static requirements that reduced the number of flight tests necessary to gauge each new design change or update. Particular aircraft configurations may be simulated in a p-static environment to determine whether the configuration creates RF noise that is above a threshold signal to noise ratio. Multiple configurations may be simulated to determine which design has the highest performance under p-static conditions. By reliably performing such analysis through modeling with fewer flight tests, such an approach may speed up the certification process, reduce cost, add confidence to passing certification tests, and allow for quicker design iterations.

The disclosed methodology allows for the development of guidelines for exterior dielectric materials (e.g., decals) and unbonded conductive materials (e.g., paints, speed tape), and can aid in improving p-static wick placements, particularly when modeling non-traditional aircraft. Additional embodiments include application of this model to predict space charging interference for spacecraft (satellites, manned and unmanned spacecraft). Portions of the model can also be used to aid with aircraft lightning zoning.

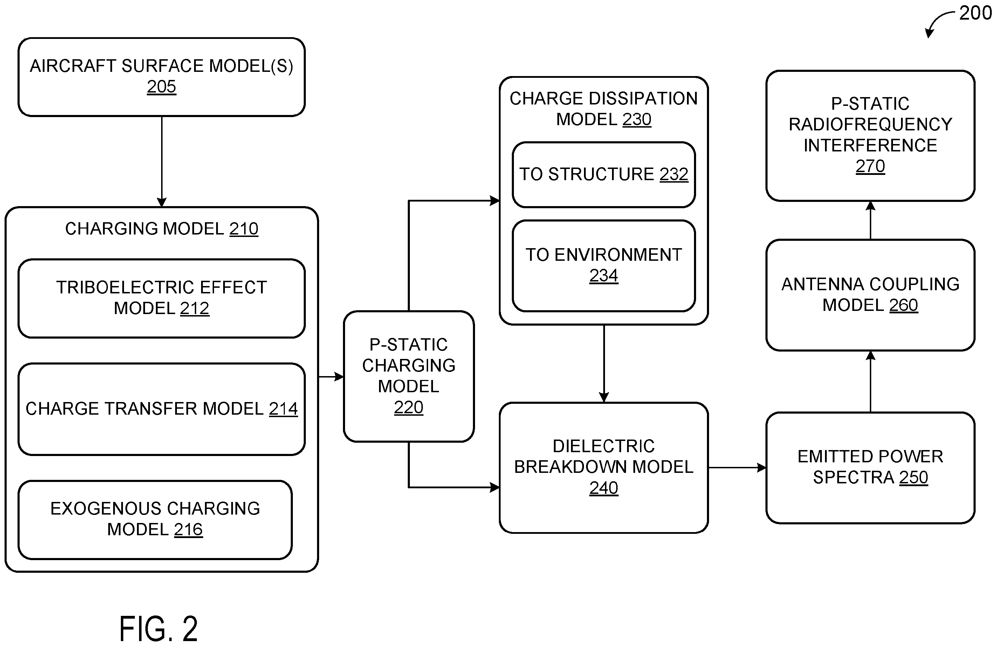

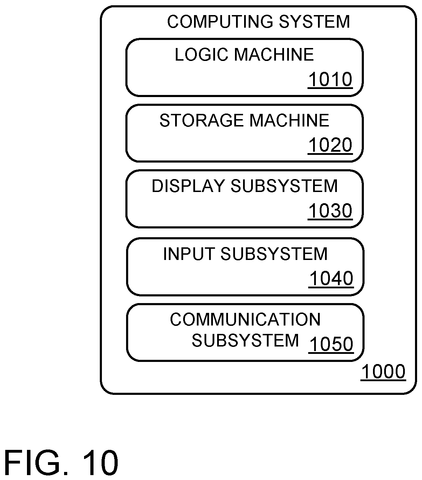

FIG. 2 schematically shows an example modeling system 200 for evaluating p-static radiofrequency interference. Modeling system 200 may comprise one or more computing devices, such as the computing device described herein and with regard to FIG. 10. Aircraft surface models 205 may comprise computer aided drafting (CAD) models that describe the surface geometry, surface materials, etc.

A charging model 210 may describe the charging current density for each aircraft surface model 205. Charging model 210 comprises a triboelectric effect model 212 which describes surface charging due to particle contact with aircraft surfaces, a charge transfer model 214 which describes charged particle exchange as charged particles leave aircraft surfaces, and an exogenous charging model 216 which describes ambient electric field charging due to a relatively strong electric field in the atmosphere. Charging model 210 may output a p-static charging model 220. The resulting p-static charging model 220 describes charge dissipation and discharge from isolated charge density due to p-static.

The charging model is aimed at predicting the p-static threat from the environment and different external aircraft surfaces. Once the aircraft charging threat is established, the charge built up on the aircraft surfaces dissipates through the aircraft. P-static charging model 220 may be provided to a charge dissipation model 230, which describes built-up surface charge leaving the aircraft surface to the aircraft structure 232 and to the environment 234. If the electric fields increase above a threshold amount, get high enough, then dielectric breakdown can occur between aircraft components and each other or aircraft components and the ambient environment. This dielectric breakdown can create a spike in voltage and current that results in radiated and conducted electromagnetic emissions that can couple to aircraft systems such as HF, VHF, VOR, or ADF antennas.

An adjusted p-static charging model that accounts for charge dissipation is provided to a dielectric breakdown model 240 which describes arc emissions from the aircraft surface. Emitted power spectra 250 are generated from dielectric breakdown model 240 and presented to one or more antenna coupling models 260. Antenna coupling model 260 uses the HF antenna as the victim or receive antenna. Radiative and conductive interference 270 produced by such discharge with radio communication system at High-Frequencies is then generated, and interference of p-static discharge as a function of position relative to the victim antenna is determined.

Modeling system 200 may be used to create models that inform design solutions and design requirements for aircraft to allow for confident prediction and mitigation of p-static interference issues. This model-based approach allows from p-static evaluation of new aircraft surface design and static discharger design while reducing the need to run expensive flight test campaigns with long duration to execute.

Model data may be augmented and/or validated based at least on real-world data. For example, flight test data may include instrumented static discharger currents measured during p-static flight tests. P-static flight tests typically instrument the outboard-most static dischargers with current probes. Charge patch data may be generated from metal patches placed on the surface of the aircraft. Spectral data may be recorded from any, some, or all aircraft antennas. Audio recordings from communication and navigation systems may offer qualitative signal-to-noise data. Additional data may include flight test notes on p-static noise, weather conditions, types of clouds, etc. Flight data may include latitude, longitude, airspeed, altitude, and angle of attack. Ground test data may include charging currents from high voltage power supplies, test locations of the aircraft surface, spectral data from the antennas and audio recordings from communication and navigation systems. Laboratory test data may include charging currents impressed on test articles, dimensional information of any devices under test, spectrum analyzer raw data, and complete documentation of the antenna, environment, and impedance matching network.

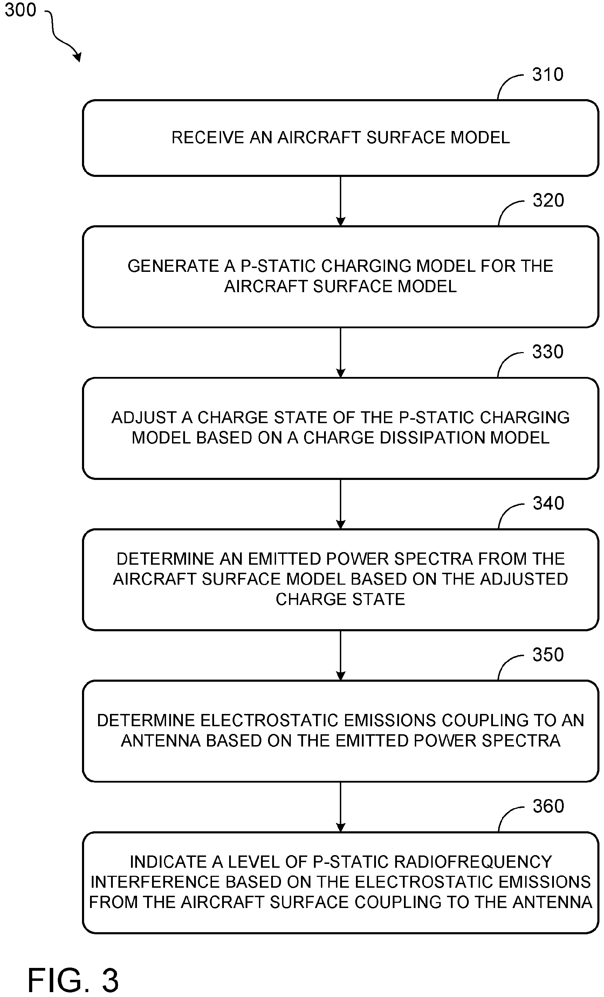

FIG. 3 shows a flow diagram for an example method 300 for evaluating p-static radiofrequency interference. Method 300 may be performed in conjunction with one or more computing devices. An example computing device is described herein and with regard to FIG. 10. Method 300 may be performed in conjunction with one or more aircraft.

At 310, method 300 comprises receiving an aircraft surface model, such as aircraft surface model 205. At 320, method 300 comprises generating a p-static charging model for the aircraft surface model. For example, p-static charging model 220 may be generated by charging model 210. The p-static charging model may be based at least on a triboelectric effect model, e.g., triboelectric effect model 212. The triboelectric effect describes charge transfer between two objects due to contact or slide against each other. For aircrafts, this effect is most often observed with precipitation particles such as snow, ice, or rain impact or slide against the aircraft surface. However triboelectric charging can also be created from dust impact to the aircraft.

The frontal surface area that participates in the triboelectric charging depends on the geometry of the aircraft, aircraft velocity, particle size, and particle density. This dependence is due to the interaction of the airstream with the charged particles. For example, larger diameter particles tend to impinge on the aircraft further aft than smaller particles. Aircraft velocity has two effects on the triboelectric charging; (1) at higher velocities, the aircraft interacts with more particles and (2) charge transfer from an individual particle increases with particle size.

Triboelectric effect model 212 may be used to predict the charging of the aircraft from friction with impacted ice particles. In some examples, the triboelectric effect model comprises a geometric model that accounts for number of impacting particles on the aircraft surface. An example geometric model may be based on equation 1.

$$J_t = \left\{ \begin{array}{ll} \alpha v_a n_p Q_p (\hat{w} \cdot \hat{n}) & \hat{w} \cdot \hat{n} < 0 \\ 0 \, \dfrac{\text{A}}{\text{m}^2} & \hat{w} \cdot \hat{n} > 0 \end{array} \right.$$

Equation 1

In this example, $J_t$ is the charging current density, A is the unit Amperes, $\hat{w}$ is the wind direction at the surface of the aircraft, $\hat{n}$ is the vector normal to the surface of the aircraft, $v$ is the velocity of the aircraft, $n_p$ is the number of particles, and $Q_p$ is the charge of the particles. $\alpha$ is a correction factor.

The geometric model estimates the charging profile of the aircraft due to the airflow around the aircraft surface, e.g., based on generating a dot-product of the wind direction with the normal vector to the aircraft surface. Direct airflow impinging directly on a surface yields higher charge.

In some examples, the triboelectric effect model comprises a particle impingement model that accounts for particle interaction with an air stream using computational fluid dynamics. Such a model efficiently yields accurate charging profile and charge densities. This model provides higher accuracy than the geometric model with modest computational power. An example model may be based on equation 2.

$$J_t = \alpha v_a n_p Q_p \beta \hat{n}$$

Equation 2

The geometric approximation of the triboelectric charging current accounts for the particle impact on various aircraft surfaces based on the aircraft's angle of attack, the incremental surface of the aircraft and the wind direction at the surface of the aircraft. Charging current may be set to 0 anywhere the wind direction is pointing away from the aircraft because no particles are impinging on the aircraft at these locations. High charging areas trend towards the leading edge of the aircraft. $\beta$ is defined as the local droplet flux rate at the body surface normalized to the freestream flux rate. $\beta$ is a function of droplet size and can be expressed as the local impingement efficiency for any point on the body surface.

Method 300 may comprise generating a particle impingement model for an aircraft surface using computational fluid dynamics (CFD). The CFD model is a computational calculation often performed with regard to icing impingement and buildup on the nacelle lips (e.g., part of the wing repair area with cumulative area applicable to both wing and nacelles.) or wings. The CFD model may be considered a ballistic model (e.g., Navier-Stokes based model derivation) where particles of differing sizes may be put into analysis to determine where the impingement locations are on the aircraft surface. The analysis may account for wind speed and other atmospheric conditions, but may be considered static e.g., does not consider motion. In some examples, other ballistic models may be employed.

In some examples, the triboelectric effect model accounts for differences in surface materials on the aircraft surface model. An example model may be based on equation 3.

$$J_t = \left(\phi_i - \phi_j\right)\frac{\epsilon_0}{\delta_e}\pi s^2 n_p v_a \beta \hat{n} - \frac{1}{2}\left(\sigma_j - \frac{Q_p}{2\pi r^2}\right)\pi s^2 n_p v_a \beta \hat{n}$$

Equation 3

Equation 3 describes the charge exchange per unit area during the collision of two particles $i$ and $j$ based on surface work functions $\phi_i$ and $\phi_j$. $\varepsilon_0$ is the permittivity of free space; $\delta$ is the cutoff distance of charge transfer (typically 500 nm) $\sigma$ is the charge transfer per particle impact, $n_p$ is the particle density, s is the particle radius, and $v_a$ is the aircraft velocity. The electric field between two particles may be approximated as the electric field at point $r$ between a point charge $Q_p$ of the particle and infinite plane of charge density $\sigma_j$. The work functions for the ice crystals and aircraft surface are likely not quantified and can depend on water absorption of the aircraft surface, shape of the granules, presence of impurities, and particle size.

Two terms of Equation 3 account for how many particles are hitting a given area of the aircraft, e.g., $\beta$ x $n$. The velocity of the aircraft is also accounted for. The first of the two terms of Equation 3 accounts for the differences in the materials ($\phi$) between the two impinging surfaces. As such, both the particle material that's impacting aircraft, e.g., ice, dust, and the material of the dielectric or metal of the aircraft surface, are accounted for. The second of the two terms of Equation 3 accounts for the differences in the electric field. There are different electric fields in different areas of the aircraft surface, which will invoke differences in charge transfer based on the localized electric field.

A model such as Equation 3 considers how many particles are hitting different parts of the aircraft surface, and also accounts for work functions for charge exchange through friction charging. This modeling may comprise implementing particle impact charging equations that convey particle to surface interactions that occur between two surfaces of unlike material as they come in contact with each other, e.g., an ice particle and the aircraft surface. Such modeling accounts for the electric field and material differences between the two surfaces. This model can be used to compare different material properties, such as speed tape, decals, dielectrics, and paint on the aircraft surface, as well as comparing aircraft structures and skin shapes. This model provides high fidelity results, albeit using increased computational power compared to models based on Equations 1 and 2.

The geometric model of Equation 1 may overestimate the frontal surface area compared to the CFD models because it does not account for particle deflection from the airstream. However, this simplified approach could serve as a conservative estimate for aircraft charging. For the CFD result, the total surface charge increases with particle size. This effect is likely due to larger diameter particles being less likely to be deflected by the airstream than small particles. The models that create the maximum charging current density also create the minimum mean charging current density, and vice versa. The total current can be calculated through integrating the charging current density over the surface of the aircraft.

In some examples, the p-static charging model is based at least on a charge transfer model, such as charge transfer model 214. Electrons or ions impact or leave the aircraft surface, resulting in a net change in charge. Generally, relatively heavy ions are more likely to impact the aircraft surface because relatively light electrons are more affected by the airstream. Herein, the term charge transfer model also encompasses engine charging. Engine charging may occur due to a number of reasons. For example, electron-ion pairs are often in the combustion phase, then ejected. Because the electron mobility is higher than the ion mobility, electrons succeed in reaching the aircraft surface and not ions. Additionally, or alternatively, relatively large, positively charged clusters (e.g., $Al_2O_3$) are emitted from engines, leading to a negative net charge on the aircraft surface.

In some examples, the p-static charging model is based at least on an exogenous charging model, such as exogenous charging model 216. Exogenous charging model 216, may also be referred to as ambient electrical field charging. Exogenous charging occurs when the aircraft flies through a relatively strong electric field which induces a voltage across the aircraft. This voltage separates charge and can create high localized electric fields. Exogenous charging is most extreme when the electric field is aligned directly with the chord or span directions of the aircraft. In some examples, exogenous charging may be ignored, as exogenous charging is more symptomatic of a lightning strike environment and represents an order of magnitude lower current for the entire aircraft as compared to triboelectric charging.

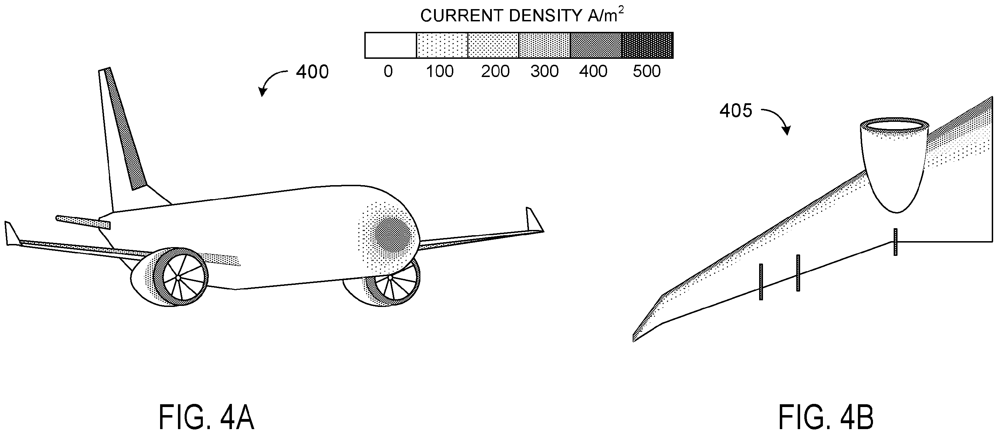

FIG. 4A shows a head-on depiction of an aircraft 400. FIG. 4B shows an underside of an aircraft wing 405. Portions of the depicted aircraft in white have a negligible value for $A/m^2$, used as a measure of current density. More densely speckled portions of the depicted aircraft have progressively larger values for $A/m^2$. Current charge density (for particle sizes of 200 $\mu m$) is notable in aircraft surface regions including on the nose of the aircraft, on the leading edge of the wings, on the engine housings, on the leading edge of the stabilizers, and on the leading edge of the fin.

At 330, method 300 comprises adjusting a charge state of the p-static charging model based on a charge dissipation model. When the aircraft is subjected to p-static charging, the propensity of nuisance electrostatic discharges being generated depends greatly on the ability of the aircraft surface to dissipate the charge. Proper charge dissipation prevents electric fields from reaching dielectric breakdown thresholds. Charge dissipation is generally ensured by methods that include adequate bonding and grounding of conductors and use of static dissipating plastics and coatings instead of dielectrics. This bonding allows charge to migrate from its impingement locations to the aircraft grounding networks.

Once on the grounding network, the charge still poses an electrostatic threat if too much is accumulated. Therefore, aircraft rely on precipitation static dischargers to generate corona at the trailing edge of wings, horizontal stabilizers, and vertical stabilizers to dissipate the charge to the atmosphere. These dischargers purposely generate corona discharge in series with a high resistor. The resistor prevents discharges with great enough current to create unwanted noise.

Charge dissipation model 230 describes the charge state of the aircraft in a way that may be used to design static wicks, both in terms of number of wicks and placement of wicks on the aircraft surface. This modeling may be provided through limiting allowable aircraft charge voltage. Charge dissipation model 230 treats the aircraft as a charging and discharging capacitor, assuming instantaneous current conduction. As current flows over the surface of the aircraft, some is discharged to the surrounding environment as a result of corona discharge, and some is discharged through p-static wicks. Dissipation to environment 234 may include a corona discharge model. Dissipation to structure 232 may include discharge current modeling via the p-static wicks.

Other examples of charge dissipation model 230 may include finite element method and finite difference time domain (FDTD) approaches that model how charge moves throughout the aircraft. Such solutions may allow for more temporal analysis, which in turn may aid in analyzing aircraft surface components such as dielectrics and plastic materials, which do not lend themselves to instantaneous charge flow. Surface components such as the radome and windshield comprise limited amounts of conductive materials, and thus charge drains more slowly than for other components of the aircraft surface.

As an example, charge takes time to dissipate from the radome, depending on the materials used in the radome surface (e.g., anti-static coatings). Material inputs to the aircraft surface may be input using parameters such as surface resistivity and permittivity measurements.

Charge dissipation model 230 may assume that the outer surfaces of the aircraft are well-connected to the aircraft ground and charge therefore dissipates in the aircraft much faster than it would take for localized charge to accumulate. This assumption results in application of instantaneous charge dissipation. This instantaneous charge dissipation then shows where the highest electric fields are generated resulting from the aircraft geometry, allowing for prediction where discharge will occur.

This electric field allows for optimization of static discharge locations. The result of the instantaneous charge dissipation model allows for calculation of the aircraft capacitance that, when analyzed with the p-static charging current and corona discharging current, allows for optimization of the number of static dischargers.

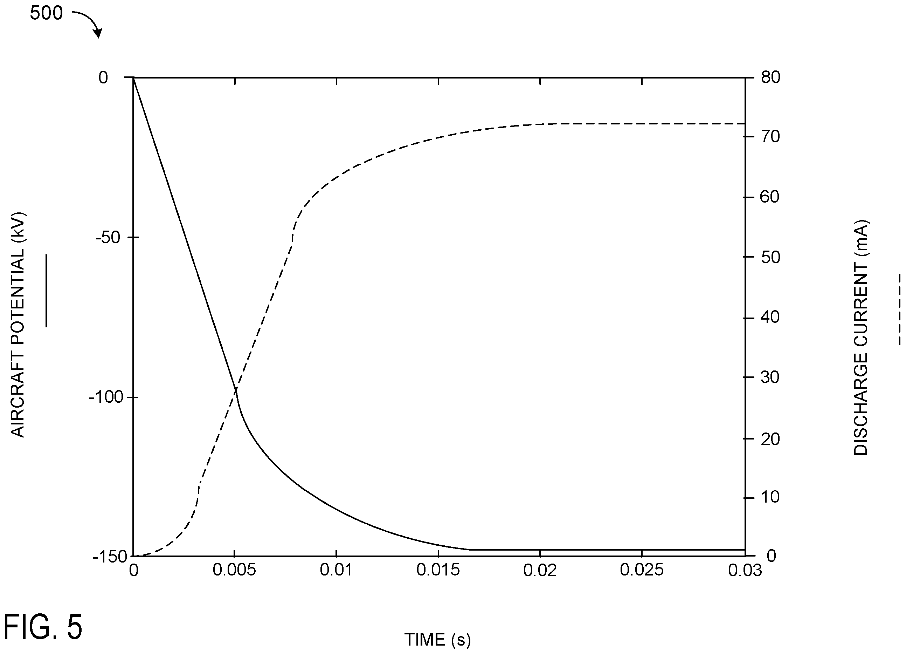

The charge state of the entire aircraft can be defined as capacitor charging and discharging based on the aircraft capacitance, the aircraft voltage, the charging current (e.g., based on p-static charging model 220), and the discharge current. The charging current may be based on the sum of the triboelectric charging integrated over the aircraft surface and engine charging. The discharge current is determined by corona discharge of the aircraft and is a function of the localized electric field on the aircraft surface. The discharge current may be further based on air density at aircraft altitude, the negative ion mobility in air, and the breakdown threshold of air. FIG. 5 shows an example plot 500 of aircraft potential and discharge current for an aircraft surface over time.

Returning to FIG. 3, at 340, method 300 comprises determining an emitted power spectra from the aircraft surface model based on the adjusted charge state. For example, the adjusted charge state output by charge dissipation model 230 is provided to dielectric breakdown model 240. Dielectric breakdown model 240 may be utilized to analyze known p-static discharging solutions for in-service aircraft to estimate an acceptable voltage threshold. This voltage threshold can then be used for static discharger optimization for future aircraft.

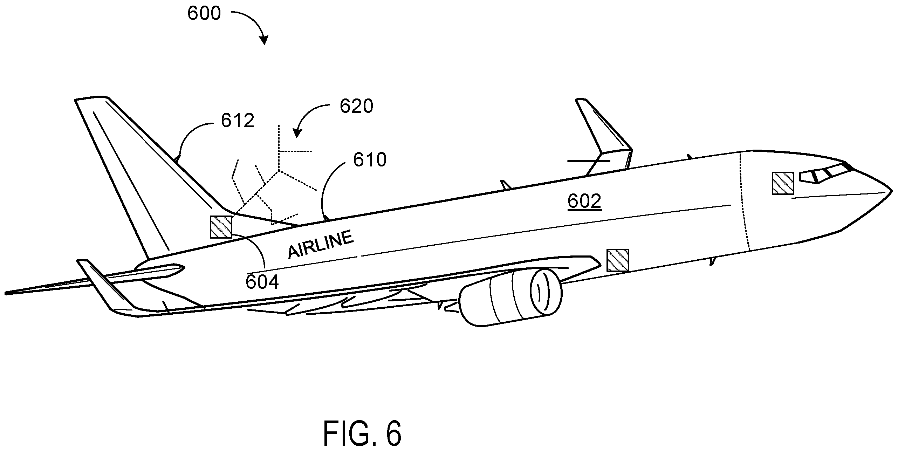

Propagating electromagnetic waves may propagate through the metal of the aircraft or through the air as radiofrequency emissions. FIG. 6 shows an example aircraft 600 having an aircraft surface 602. A speed tape patch 604 is positioned on the aircraft fin, in proximity to antenna 610 and 612. Arc emissions 620 may spark from speed tape patch 604, propagating through aircraft surface 602 and the atmosphere, yielding potential RF interference at antennas 610 and 612.

The primary mechanism for p-static interference is from the radiated and conducted fields from plasma discharge. This discharge creates a spike in current, which, with the large voltage accumulated to create the arc, results in relatively high electric and magnetic fields. For conductors, the frequency of these fields depends on the geometry of the conductor because the discharge creates current flow through the entire conductor. For dielectrics, charge transfer is more localized, with each individual discharge being lower magnitude current than what would be created from a conductor. However, because dielectrics do not discharge their entire volume during an arc event, the number of discharges per second can be greater than that for conductors. The following variables are suspected to impact the magnitude and frequency of the electromagnetic fields created by these plasma discharges: material and surrounding material conductivity, material and surrounding material permittivity geometry of discharger, geometry of object being discharged to (could be air), geometry of discharge media, discharge media material, discharge characteristics such as ambient pressure, temperature, and any aspects that can impact the resistance of the plasma discharge. Dielectric breakdown model 240 may be used to characterize the radiated fields from discharging materials that have the ability to consider the parameters listed above.

The dielectric breakdown model may be utilized to determine arc emissions (e.g., electromagnetic emissions) from patches of the aircraft surface. A finite difference time domain (FDTD) model may be utilized to calculate emitted power spectra from the aircraft surface with arc discharges. As described, the aircraft surface is charged with impressed current density from triboelectric charging. Once a voltage threshold is reached between the aircraft surface and ground plane, an arc is initiated at the point where voltage is above threshold. The voltage arc is sustained while the current is above a sustainment threshold. The current surge creates a propagated electromagnetic wave that can interfere with the aircraft antennas. The dielectric breakdown model allows for characterization of emission spectrum from arc between various materials/ material implementations.

A FDTD model may be used to characterize the radiated fields at least by solving Maxwell's time domain equations. Inputs to the model may include permittivity and permeability of the media. Outputs of the model can include an electric field strength vector, an electric displacement vector, a magnetic field strength vector, a magnetic flux density vector, an electric current density vector, a magnetic current density vector, an electric charge density, and a magnetic charge density.

In some examples, curl equations are considered, but not divergence equations, as the divergence equations are inherently satisfied by the developed FDTD updating equations. The electric current density may be expressed as the sum of the conduction current density and the impressed current density. Similarly, magnetic current density may be expressed as the sum of conduction current density and impressed current density. The impressed current density is used to deposit triboelectric charge to the aircraft surface. The results of the curl equations can be checked with Maxwell's divergence equations while considering the constitutive relationships. These equations may be expressed as scalar equations, then solved through temporal and spatial discretization using the central difference approximation and solved iteratively. This concept may be used to spatially discretize the described equations using Yee cells. The Yee cell is a cuboid discretization with side lengths $\Delta x$, $\Delta y$, and $\Delta z$. The electric field is solved at the center of each edge of the cuboid and the magnetic field is solved at the center of each face. Electric field and magnetic field may be updated temporally at discrete time stamps.

In some formulations, the radiated power solved by the FDTD approach would approach zero Watts because the boundaries of the model domain would reflect electromagnetic fields. To prevent this from happening, convolution perfectly matched boundary layers (CPML) that absorb the electromagnetic fields may be implemented. The geometry consists of a plate over a ground plane surrounded by an air-filled computational domain that allows the electromagnetic fields to propagate to the CPML. The ground plane expands to the entire width and length of the computational domain, which mathematically represents it as infinite size. The plate is offset, a distance d from the ground plane, and has finite length, width, and height. This geometry may be evenly discretized with Yee cells of dimension, $\Delta x$, $\Delta y$, and $\Delta z$. The top surface of the ground plane is the mid surface of the computational domain.

When the voltage between the plate and ground plane exceeds a dielectric breakdown threshold, $V_{thresh}$, a voltage arc occurs. This voltage arc may be represented through adding a resistor of resistance $R$ between the plate and ground plane where the voltage exceeds the $V_{thresh}$. The resistor may be left in place until the current decreases below a sustainment threshold, $I_{\cdot}$, at which time the resistor may be removed. The voltage can then be calculated between the plate and ground plane at each Yee cell defining the plate. The discharge current can then be solved for each resistor. To add a resistor to the updating coefficients, a term accounting for the additional resistivity to the electric field may be added.

To simulate tribo-electric charging of the plate, impressed current may be assigned at the top surface of the plate geometry. In addition to the voltage measured between the plate and ground plane, the current between the plate and ground plane may also be probed over bounding points that enclose the region between the plate and ground plane. Finally, the Poynting vector may be integrated over a surface surrounding the plate, plate-ground plane gap, and bottom of the ground plane directly below the plate. This integration yields a total radiated power at each time step. A Fourier Transform of the total radiated power result then gives the frequency spectrum of the radiated power.

The FDTD discharge model thus generates in three phases. During a first phase, the plate is accumulating charge and has not yet reached the discharge voltage threshold. During this first phase, the Poynting vector has the greatest magnitude at the edges of the plate as the charge seeks to find homeostasis. The ground plane may be set at $z=0$ mm, below which the electromagnetic field significantly decreases, reducing the Poynting vector to near 0 W/m². As an example, the plate may be charged with 10 A/m² to decrease the simulation time required to create discharge. One implementation is to have high charging current until the initial discharge occurs, then decreasing to a current more representative of p-static charging. During the second phase, an electromagnetic wave front can be observed radiating from the discharge with subsequent wave peaks and troughs from later discharges. These wave fronts interfere with each other creating the observed pattern. This pattern is affected by the assumption made governing the creation and deletion of resistor representing discharge arcs. During the third phase, the discharges create the observed interference pattern in the Poynting vector. A strong effect of the ground plane surface can be observed on the radiated field that extends the ground plane surface.

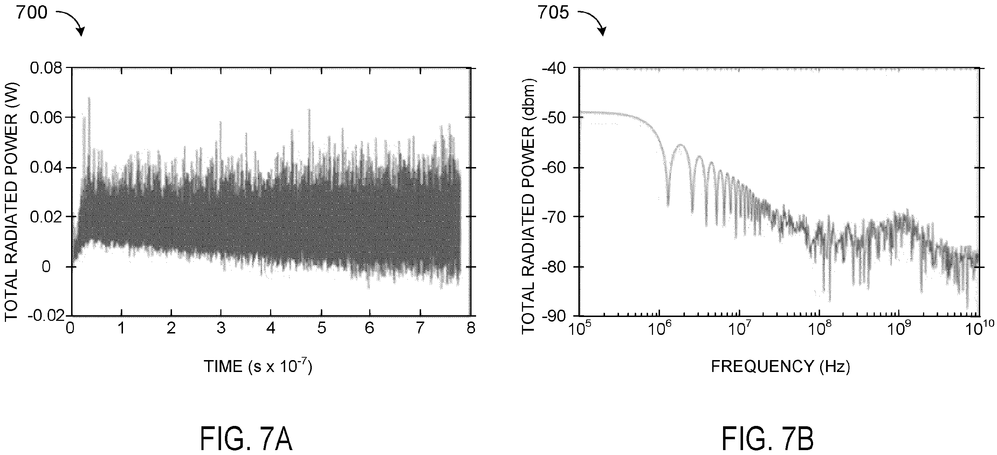

FIG. 7A shows an example plot 700 of total radiated power from the FDTD discharge model in the time domain. FIG. 7B shows an example plot 705 of total radiated power for plot 700 transformed into the frequency domain. Running the model for a longer duration may aid in resolving the power response at lower frequencies (~1 MHz). Similar modeling may aim to compare the power spectrum from different materials and geometries to better classify the acceptable radiated power used on current aircraft. P-static requirements can then be generated from new material application to the aircraft surface. Taking a Fourier transform of the emissions spectra to convert to the frequency domain may allow for ease of use as an input to antenna coupling model 260 (e.g., methods of moments models).

Returning to FIG. 3, at 350 method 300 comprises determining electrostatic emissions coupling to an antenna based on the emitted power spectra. HF antenna models can predict coupling by using emitted output spectra of the dielectric breakdown models. Such antenna models may be analyzed in the time domain or the frequency domain. An example time-domain model focuses on the effect of conductive patches on surface waves. Frequency model results can be compared to lab data with an appropriate matching network. As shown herein, frequency domain results for radio-frequency emissions ($Z_{in}$)have similar form as measured albeit at a higher resonant frequency.

HF antennas may be modeled as receivers to the emitted output spectra of the dielectric breakdown models. Fields from electrical discharges may also be modeled as electrically short antennas above ground planes. In some examples herein, short monopole antennas are placed on the fuselage barrel (ground plane) to assess the coupling over a range of frequencies as well as in the time domain. The fields and key quantities of the emitted output spectra are inputs to the antenna modeling software, which may be designed to model intentional radiators. Electrical discharges are unintentional radiators whose frequency spectra are dependent on several factors.

Computational modeling may be performed to generate a model for a receive antenna. Material properties may be assigned to a CAD model and then excitation codes used to effectively model a proper HF antenna. To create a model environment, dipole representations may be used to approximate the emitted power spectra from the dielectric breakdown model. A 1st order approximation may be used to understand how the radiated field will couple into the model HF antenna, either through a radiative mechanism, or a surface wave. Effectively, the model simulated the propagation of an electromagnetic wave from a first point of observation (transmit antenna, e.g., speed tape patch) to a second point of observation (e.g., the HF antenna). How those waveforms propagate depends on the different material codes on the model surface.

Half wavelength dipoles can be placed at various positions to understand how emitted waves will couple into a receive antenna that is placed on the aircraft. To validate the model, measured data in the frequency domain (e.g., impedance) may be compared to the modeled data. Once the model is validated, it may also be run in the time domain.

Analysis in the frequency domain allows for analysis of the spectral properties of the antenna, e.g., where there is interference over a wide range of frequencies. Analysis in the time domain allows for an understanding of how the EM wave propagates in the presence of a different coating on the fuselage or different fuselage materials.

The space around the receive antenna can be divided into two main regions, namely, far field and near field. In the far field, electric and magnetic fields propagate outward as an electromagnetic wave and are perpendicular to each other and to the direction of propagation. The angular field distribution does not depend on the distance from the antenna. The fields are uniquely related to each other via free-space impedance and decay as $1/r$. In the near field, the field components have different angular and radial dependence. The near field region includes two sub-regions: radiating, where the angular field distribution is dependent on the distance, and reactive, where the energy is stored but not radiated. For electrically small antennas (such as discharge from a speed tape), the boundary between the far field and the near field regions is commonly given as $\lambda/2\pi$. Thus, for an antenna with $\lambda$ at 100-10 m (3-30 MHz), the near field would be roughly 53 ft to 5 ft. Therefore, near-field simulation techniques may be employed to study the impact of radiative and conductive coupling. The signal coupled into a receiver from a discharge of current at any point on the aircraft surface is proportional to the electric field which would be produced at the point of discharge by a voltage applied across the antenna terminals of the receiver. Coupling from discharges on the aircraft surface may also depend on the electromagnetic resonances of the aircraft surface. As coupling is a function of frequency, the model may be further tuned by adding a matching network.

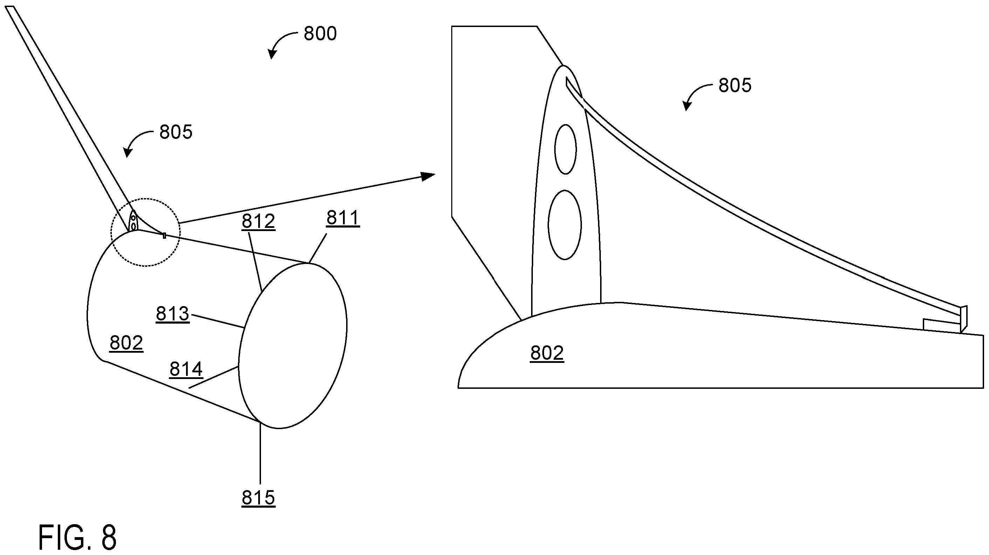

To simulate the coupling of electromagnetic discharge energy to the antenna of an aircraft, an HF antenna model was created using a computational electromagnetics software package. In one example, the geometry of the model is based on models that stem from a comparative analysis of a proposed example antenna. In this work, the HF antenna of the first production aircraft was modeled first, since the barrel test of its HF antenna had reliable input impedance data. FIG. 8 shows an example model 800 of a high frequency antenna. A fuselage is modeled at 802, while a high frequency antenna is modeled at 805.

To begin to understand the coupling between the HF antenna and an electrical discharge on the outer mold line (OML), five electrically short monopole antennas (811, 812, 813, 814, 815) were placed around the barrel of the model 800. However, five antennas are merely illustrative, and both more and fewer antennas are within the scope of the invention. The angular positions relative to the HF antenna were 0°, 45°, 90°, 120°, and 180°.

Each dipole was tested in separate simulation runs to determine its coupling to the target antenna. The transmit and receive antennas share the fuselage as a ground plane in this configuration. To avoid issues with impedance mismatching, the max coupling can be calculated in the computational electromagnetics software to get the theoretical maximum coupling - assuming perfect matching - between both antennas. This coupling analysis shows a maximum coupling between the two antennas around 5 MHz and the highest overall coupling for the 0° antenna.

Time domain models may also be used to analyze antenna interference. One approach is modeling a simplified version of the HF antenna to compare the S-parameters from a time domain and frequency domain simulation. This model can then be run with a monopole excitation to compare time and frequency domain coupling results. Having a time domain antenna coupling model will allow direct input of a FDTD arc discharge result into the model. Despite being a time domain simulation, the model may also calculate a Fourier transform of the results and report them over specified frequency values. This transformation allows for a direct comparison of surface currents, for example, at given frequencies.

Another approach using time domain modeling is to analyze the effect on surface/creeping waves due to decals or speed tape that is located between an emission and the receiving (victim) antenna. These waves likely will be partially reflected by the change in characteristic impedance as they encounter metallic patches with conductivities or permittivities different from free space.

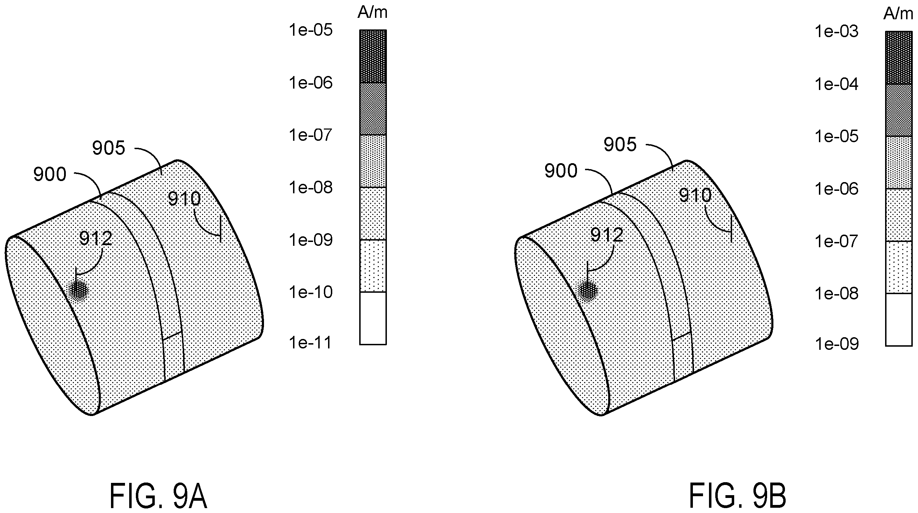

An example time-domain model is shown in FIGS. 9A and 9B. In such a model, the thin, conductive coating of the fuselage carbon fiber and speed tape may be emulated. The initial model comprises a conductive strip 900 around a 200" diameter cylinder 905 representing a fuselage barrel. As examples, four different combinations of material assignments have been considered: lossy aluminum barrel with no tape, 0.25" thick carbon fiber-reinforced polymer (CFRP) barrel with no tape, 0.25" thick CFRP barrel with lossy aluminum strip (no adhesive), and 0.25" thick CFRP barrel with aluminum speed tape. To model speed tape with the conductive strip, the thickness was set to 3 mil aluminum with a 1 mil thick layer of epoxy resin to mimic an adhesive backing. All strips were 20" wide and wrapped halfway around the barrel.

Strip 900 is located between two dipole antennas 910 and 912 whose common ground plane is the barrel. A series of convergence tests were conducted on different mesh resolutions and simulated run times. It was found a simulation of 10 $\mu$s gave reasonable Fourier transform results at low frequencies. The mesh resolution was set to 60 cells per wavelength close to the model and 15 far away. FIG. 9A shows the surface current density at 10MHz. FIG. 9B shows the surface current density at 100MHz.

Returning to FIG. 3, at 360, method 300 comprises indicating a level of p-static radiofrequency interference based on the electrostatic emissions from the aircraft surface coupling to the antenna. In some examples, method 300 may comprise comparing the level of p-static radiofrequency interference to a p-static radiofrequency threshold and indicating p-static compliance based on the comparison.

In some examples, method 300 may comprise receiving two or more aircraft surface models and indicating a level of p-static radiofrequency interference based on the electrostatic emissions from the aircraft surface coupling to the antenna for each aircraft surface model. Method 300 may further comprise indicating a better performing aircraft surface model based on the indicated levels of p-static radiofrequency interference for each aircraft surface model. the two or more aircraft surface models comprise differing model geometries.

The two or more aircraft surface models may comprise different surface materials. The different surface materials may comprise different configurations of unbonded isolated conductors, such as speed tape and/or decals. The two or more aircraft surface models may comprise different p-static wick positioning, including spatial placement and/or number of p-static wicks. The two or more aircraft surface models may comprise different antenna configurations, such as antenna type, antenna gain, antenna placement, etc.

FIG. 10 schematically shows a non-limiting embodiment of a computing system 1000 that can enact one or more of the methods and processes described above. Computing system 1000 is shown in simplified form. Computing system 1000 may take the form of one or more personal computers, server computers, tablet computers, home-entertainment computers, network computing devices, gaming devices, mobile computing devices, mobile communication devices (e.g., smart phone), and/or other computing devices.

Computing system 1000 includes a logic machine 1010 and a storage machine 1020. Computing system 1000 may optionally include a display subsystem 1030, input subsystem 1040, communication subsystem 1050, and/or other components not shown in FIG. 10. Computing system 1000 may be utilized to perform steps of method 300, for example. Modeling system 200 may be an example of computing system 1000.

Logic machine 1010 includes one or more physical devices configured to execute instructions. For example, the logic machine may be configured to execute instructions that are part of one or more applications, services, programs, routines, libraries, objects, components, data structures, or other logical constructs. Such instructions may be implemented to perform a task, implement a data type, transform the state of one or more components, achieve a technical effect, or otherwise arrive at a desired result.

The logic machine may include one or more processors configured to execute software instructions. Additionally or alternatively, the logic machine may include one or more hardware or firmware logic machines configured to execute hardware or firmware instructions. Processors of the logic machine may be single-core or multi-core, and the instructions executed thereon may be configured for sequential, parallel, and/or distributed processing. Individual components of the logic machine optionally may be distributed among two or more separate devices, which may be remotely located and/or configured for coordinated processing. Aspects of the logic machine may be virtualized and executed by remotely accessible, networked computing devices configured in a cloud-computing configuration.

Storage machine 1020 includes one or more physical devices configured to hold instructions executable by the logic machine to implement the methods and processes described herein. When such methods and processes are implemented, the state of storage machine 1020 may be transformed-e.g., to hold different data.

Storage machine 1020 may include removable and/or built-in devices. Storage machine 1020 may include optical memory (e.g., CD, DVD, HD-DVD, Blu-Ray Disc, etc.), semiconductor memory (e.g., RAM, EPROM, EEPROM, etc.), and/or magnetic memory (e.g., hard-disk drive, floppy-disk drive, tape drive, MRAM, etc.), among others. Storage machine 1020 may include volatile, nonvolatile, dynamic, static, read/write, read-only, random-access, sequential-access, location-addressable, file-addressable, and/or content-addressable devices.

It will be appreciated that storage machine 1020 includes one or more physical devices. However, aspects of the instructions described herein alternatively may be propagated by a communication medium (e.g., an electromagnetic signal, an optical signal, etc.) that is not held by a physical device for a finite duration.

Aspects of logic machine 1010 and storage machine 1020 may be integrated together into one or more hardware-logic components. Such hardware-logic components may include field-programmable gate arrays (FPGAs), program- and application-specific integrated circuits (PASIC / ASICs), program- and application-specific standard products (PSSP / ASSPs), system-on-a-chip (SOC), and complex programmable logic devices (CPLDs), for example.

The terms "module," "program," and "engine" may be used to describe an aspect of computing system 1000 implemented to perform a particular function. In some cases, a module, program, or engine may be instantiated via logic machine 1010 executing instructions held by storage machine 1020. It will be understood that different modules, programs, and/or engines may be instantiated from the same application, service, code block, object, library, routine, API, function, etc. Likewise, the same module, program, and/or engine may be instantiated by different applications, services, code blocks, objects, routines, APIs, functions, etc. The terms "module," "program," and "engine" may encompass individual or groups of executable files, data files, libraries, drivers, scripts, database records, etc.

It will be appreciated that a "service," as used herein, is an application program executable across multiple user sessions. A service may be available to one or more system components, programs, and/or other services. In some implementations, a service may run on one or more server-computing devices.

When included, display subsystem 1030 may be used to present a visual representation of data held by storage machine 1020. This visual representation may take the form of a graphical user interface (GUI). As the herein described methods and processes change the data held by the storage machine, and thus transform the state of the storage machine, the state of display subsystem 1030 may likewise be transformed to visually represent changes in the underlying data. Display subsystem 1030 may include one or more display devices utilizing virtually any type of technology. Such display devices may be combined with logic machine 1010 and/or storage machine 1020 in a shared enclosure, or such display devices may be peripheral display devices.

When included, input subsystem 1040 may comprise or interface with one or more user-input devices such as a keyboard, mouse, touch screen, or game controller. In some embodiments, the input subsystem may comprise or interface with selected natural user input (NUI) componentry. Such componentry may be integrated or peripheral, and the transduction and/or processing of input actions may be handled on- or off-board. Example NUI componentry may include a microphone for speech and/or voice recognition; an infrared, color, stereoscopic, and/or depth camera for machine vision and/or gesture recognition; a head tracker, eye tracker, accelerometer, and/or gyroscope for motion detection and/or intent recognition; as well as electric-field sensing componentry for assessing brain activity.

When included, communication subsystem 1050 may be configured to communicatively couple computing system 1000 with one or more other computing devices. Communication subsystem 1050 may include wired and/or wireless communication devices compatible with one or more different communication protocols. As non-limiting examples, the communication subsystem may be configured for communication via a wireless telephone network, or a wired or wireless local- or wide-area network. In some embodiments, the communication subsystem may allow computing system 1000 to send and/or receive messages to and/or from other devices via a network such as the Internet.

Further, the disclosure comprises configurations according to the following clauses.

Example 1. A method for evaluating precipitation static (p-static) radiofrequency interference comprises receiving an aircraft surface model; generating a p-static charging model for the aircraft surface model; adjusting a charge state of the p-static charging model based on a charge dissipation model; determining an emitted power spectra from the aircraft surface model based on the adjusted charge state; determining electrostatic emissions coupling to an antenna based on the emitted power spectra; and indicating a level of p-static radiofrequency interference based on the electrostatic emissions from the aircraft surface coupling to the antenna.

Example 2. The method of example 1, further comprising comparing the level of p-static radiofrequency interference to a p-static radiofrequency threshold; and indicating p-static compliance based on the comparison.

Example 3. The method of examples 1-2, wherein the p-static charging model is based at least on a triboelectric effect model.

Example 4. The method of examples 1-3, wherein the triboelectric effect model comprises a geometric model that accounts for number of impacting particles.

Example 5. The method of examples 1-4, wherein the triboelectric effect model comprises a particle impingement model that accounts for particle interaction with an air stream using computational fluid dynamics.

Example 6. The method of examples 1-5, wherein the triboelectric effect model accounts for differences in surface materials on the aircraft surface model.

Example 7. The method of examples 1-6, wherein the charge dissipation model comprises a corona discharge model.

Example 8. The method of examples 1-7, wherein the charge dissipation model accounts for positions of p-static wicks on the aircraft surface model.

Example 9. The method of examples 1-8, wherein the emitted power spectra from the aircraft surface model are determined via a finite difference time domain model that calculates emitted power spectra.

Example 10. The method of examples 1-9, wherein calculating the emitted power spectra includes integrating a Poynting vector over a surface surrounding an aircraft surface portion.

Example 11. The method of examples 1-10, wherein determining electrostatic emissions coupling to the antenna based on the emitted power spectra comprises modeling a high frequency antenna in a frequency domain using computational electromagnetics software.

Example 12. The method of examples 1-11, wherein determining electrostatic emissions coupling to the antenna based on the emitted power spectra comprises modeling a high frequency antenna using a time domain antenna coupling model.

Example 13. A computing system for evaluating precipitation static (p-static) radiofrequency interference comprises a logic machine comprising one or more processors; and a storage machine comprising instructions executable by the one or more processors to receive an aircraft surface model; generate a p-static charging model for the aircraft surface model; adjust a charge state of the p-static charging model based on a charge dissipation model; determine an emitted power spectra from the aircraft surface model based on the adjusted charge state; determine electrostatic emissions coupling to an antenna based on the emitted power spectra; and indicate a level of p-static radiofrequency interference based on the electrostatic emissions from the aircraft surface coupling to the antenna.

Example 14. The computing system of example 13, wherein the storage machine further comprises instructions executable by the one or more processors to compare the level of p-static radiofrequency interference to a p-static radiofrequency threshold; and indicate p-static compliance based on the comparison.

Example 15. A method for evaluating precipitation static (p-static) radiofrequency interference, comprises receiving two or more aircraft surface models; for each aircraft surface model: generating a p-static charging model for the aircraft surface model; adjusting a charge state of the p-static charging model based on a charge dissipation model; determining an emitted power spectra from the aircraft surface model based on the adjusted charge state; determining electrostatic emissions coupling to an antenna based on the emitted power spectra; and indicating a level of p-static radiofrequency interference based on the electrostatic emissions coupling to the antenna; and indicating a better performing aircraft surface model based on the indicated levels of p-static radiofrequency interference for each aircraft surface model.

Example 16. The method of example 15, wherein the two or more aircraft surface models comprise differing model geometries.

Example 17. The method of examples 15-16, wherein the two or more aircraft surface models comprise different surface materials.

Example 18. The method of examples 15-17, wherein the different surface materials comprise different configurations of unbonded isolated conductors.

Example 19. The method of examples 15-18, wherein the two or more aircraft surface models comprise different p-static wick positioning.

Example 20. The method of examples 15-19, wherein the two or more aircraft surface models comprise different antenna configurations.

It will be understood that the configurations and/or approaches described herein are exemplary in nature, and that these specific embodiments or examples are not to be considered in a limiting sense, because numerous variations are possible. The specific routines or methods described herein may represent one or more of any number of processing strategies. As such, various acts illustrated and/or described may be performed in the sequence illustrated and/or described, in other sequences, in parallel, or omitted. Likewise, the order of the above-described processes may be changed.

The subject matter of the present disclosure includes all novel and non-obvious combinations and sub-combinations of the various processes, systems and configurations, and other features, functions, acts, and/or properties disclosed herein, as well as any and all equivalents thereof.

## List of references numerals

| | |
|---|---|
| aircraft | 100 |
| aircraft surface | 102 |
| suspended atmospheric particles | 104 |
| speed tape patches | 110, 112, 114 |
| decal | 120 |
| Static dischargers | 130, 132 |
| Antenna | 140, 142, 144, 146, 148, 150, 152 |
| modeling system | 200 |
| Aircraft surface models | 205 |
| charging model | 210 |
| triboelectric effect model | 212 |
| charge transfer model | 214 |
| exogenous charging model | 216 |
| p-static charging model | 220 |
| charge dissipation model | 230 |
| charge dissipation to aircraft structure | 232 |
| charge dissipation to environment | 234 |
| dielectric breakdown model | 240 |
| Emitted power spectra | 250 |
| antenna coupling model | 260 |
| p-static radiofrequency interference | 270 |

(continued)

| | |
|---|---|
| method | 300 |
| Method steps | 310, 320, 330, 340, 350, 360 |
| aircraft | 400 |
| aircraft wing | 405 |
| plot | 500 |
| aircraft | 600 |
| aircraft surface | 602 |
| speed tape patch | 604 |
| antenna | 610,612 |
| Arc emissions | 620 |
| plot | 700 |
| plot | 705 |
| model | 800 |
| fuselage | 802 |
| high frequency antenna | 805 |
| electrically short monopole antenna | 811, 812, 813, 814, 815 |
| conductive strip | 900 |
| fuselage barrel | 905 |
| dipole antennas | 910, 912 |
| computing system | 1000 |
| logic machine | 1010 |
| storage machine | 1020 |
| display subsystem | 1030 |
| input subsystem | 1040 |
| communication subsystem | 1050 |

## Claims

1. A method (300) for evaluating precipitation static (p-static) radiofrequency interference (270), comprising:

   receiving (310) an aircraft surface model (205);
   generating (320) a p-static charging model (220) for the aircraft surface model (205);
   adjusting (330) a charge state of the p-static charging model (220) based on a charge dissipation model (230);
   determining (340) an emitted power spectra (250) from the aircraft surface model (205) based on the adjusted charge state;
   determining (350) electrostatic emissions coupling to an antenna (610, 612) based on the emitted power spectra (250); and
   indicating (360) a level of p-static radiofrequency interference (270) based on the electrostatic emissions from the aircraft surface (205) coupling to the antenna (610, 612).

2. The method (300) of claim 1, further comprising:

   comparing the level of p-static radiofrequency interference (270) to a p-static radiofrequency threshold; and
   indicating p-static compliance based on the comparison.

3. The method (300) of claim 1 or 2, wherein the p-static charging model (220) is based at least on a triboelectric effect model (212).

4. The method (300) of claim 3, wherein the triboelectric effect model (212) comprises a geometric model that accounts for a number of impacting particles (104).

5. The method (300) of claim 3 or 4, wherein the triboelectric effect model (212) comprises a particle impingement model that accounts for particle interaction with an air stream using computational fluid dynamics.

6. The method (300) of claim 3, 4 or 5, wherein the triboelectric effect model (212) accounts for differences in surface materials on the aircraft surface model (205).

7. The method (300) of any of the preceding claims, wherein the charge dissipation model (230) comprises a corona discharge model.

8. The method (300) of any of the preceding claims, wherein the charge dissipation model (230) accounts for positions of p-static wicks (130, 132) on the aircraft surface model (205).

9. The method (300) of any of the preceding claims, wherein the emitted power spectra (250) from the aircraft surface model (205) are determined via a finite difference time domain model that calculates emitted power spectra.

10. The method (300) of claim 9, wherein calculating the emitted power spectra (250) includes integrating a Poynting vector over a surface surrounding an aircraft surface portion.

11. The method (300) of any of the preceding claims, wherein determining (350) electrostatic emissions coupling to the antenna (610, 612) based on the emitted power spectra (250) comprises modeling a high frequency antenna (805) in a frequency domain using computational electromagnetics software; and/or wherein determining (350) electrostatic emissions coupling to the antenna (610, 612) based on the emitted power spectra (250) comprises modeling a high frequency antenna (805) using a time domain antenna coupling model.

12. A computing system (1000) for evaluating precipitation static (p-static) radiofrequency interference, comprising:

   a logic machine (1010) comprising one or more processors; and
   a storage machine (1020) comprising instructions executable by the one or more processors to:

      receive (310) an aircraft surface model (205);
      generate (320) a p-static charging model (220) for the aircraft surface model;
      adjust a charge state of the p-static charging model based on a charge dissipation model (205);
      determine (340) an emitted power spectra (250) from the aircraft surface model (205) based on the adjusted charge state;
      determine (350) electrostatic emissions coupling to an antenna (610, 612) based on the emitted power spectra (250); and
      indicate (360) a level of p-static radiofrequency interference (270) based on the electrostatic emissions from the aircraft surface (205) coupling to the antenna (610, 612).

13. The computing system (1000) of claim 12, wherein the storage machine (1020) further comprises instructions executable by the one or more processors to:

   compare the level of p-static radiofrequency interference (270) to a p-static radiofrequency threshold; and
   indicate p-static compliance based on the comparison.

14. A method for evaluating precipitation static (p-static) radiofrequency interference (270), comprising:

   receiving (310) two or more aircraft surface models (205);
   for each aircraft surface model (205):

      generating (320) a p-static charging model (220) for the aircraft surface model (205);
      adjusting (330) a charge state of the p-static charging model (220) based on a charge dissipation model (230);
      determining (340) an emitted power spectra (250) from the aircraft surface model (205) based on the adjusted charge state;
      determining (350) electrostatic emissions coupling to an antenna (610, 612) based on the emitted power spectra (250); and
      indicating (360) a level of p-static radiofrequency interference (270) based on the electrostatic emissions coupling to the antenna (610, 612); and

   indicating a better performing aircraft surface model based on the indicated levels of p-static radiofrequency interference (270) for each aircraft surface model (205).

15. The method of claim 14, wherein the two or more aircraft surface models (205) comprise differing model geometries and/or different surface materials; preferably wherein the different surface materials comprise different configurations of unbonded isolated conductors; preferably wherein the two or more aircraft surface models (205) comprise different p-static wick (130, 132) positioning; and preferably wherein the two or more aircraft surface models (205) comprise different antenna configurations.

FIG. 1

FIG. 2

EP 4 660 640 A1

300

310

RECEIVE AN AIRCRAFT SURFACE MODEL

320

GENERATE A P-STATIC CHARGING MODEL FOR THE AIRCRAFT SURFACE MODEL

330

ADJUST A CHARGE STATE OF THE P-STATIC CHARGING MODEL BASED ON A CHARGE DISSIPATION MODEL

340

DETERMINE AN EMITTED POWER SPECTRA FROM THE AIRCRAFT SURFACE MODEL BASED ON THE ADJUSTED CHARGE STATE

350

DETERMINE ELECTROSTATIC EMISSIONS COUPLING TO AN ANTENNA BASED ON THE EMITTED POWER SPECTRA

360

INDICATE A LEVEL OF P-STATIC RADIOFREQUENCY INTERFERENCE BASED ON THE ELECTROSTATIC EMISSIONS FROM THE AIRCRAFT SURFACE COUPLING TO THE ANTENNA

FIG. 3

CURRENT DENSITY A/m²

0   100   200   300   400   500

400

405

FIG. 4A

FIG. 4B

EP 4 660 640 A1

FIG. 5

FIG. 6

FIG. 7A

FIG. 7B

FIG. 8

EP 4 660 640 A1

FIG. 9A

FIG. 9B

COMPUTING SYSTEM

LOGIC MACHINE
1010

STORAGE MACHINE
1020

DISPLAY SUBSYSTEM
1030

INPUT SUBSYSTEM
1040

COMMUNICATION
SUBSYSTEM 1050

1000

FIG. 10

Europäisches
Patentamt
European
Patent Office
Office européen
des brevets

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 2015/331028 A1 (WALLACE WILLIAM W [US]) 19 November 2015 (2015-11-19) * paragraphs [0004] - [0012], [0025] - [0027], [0039] * | 1-15 | INV. G01R29/08 |
| A | HAN CHUNYONG: "Design and Application of Airborne P-Static Discharge Parameter Measurement System", 2023 IEEE 7TH INTERNATIONAL SYMPOSIUM ON ELECTROMAGNETIC COMPATIBILITY (ISEMC), IEEE, 20 October 2023 (2023-10-20), pages 1-5, XP034509928, DOI: 10.1109/ISEMC58300.2023.10370459 [retrieved on 2023-12-29] * paragraphs [II.A] - [II.B]; figure 1 * | 1-15 | |
| A | GAYNUTDINOV RUSTAM R ET AL: "Study of the Static Electricity Discharges Impact in an Unmanned Aerial Vehicle", 2022 INTERNATIONAL RUSSIAN AUTOMATION CONFERENCE (RUSAUTOCON), IEEE, 4 September 2022 (2022-09-04), pages 782-787, XP034197460, DOI: 10.1109/RUSAUTOCON54946.2022.9896249 [retrieved on 2022-09-27] * paragraphs [00II] - [0III]; figures 1-4 * | 1-15 | TECHNICAL FIELDS SEARCHED (IPC) G01R |

-/--

The present search report has been drawn up for all claims

| Place of search | Date of completion of the search | Examiner |
|---|---|---|
| Munich | 11 September 2025 | Maric, Viktor |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

Europäisches
Patentamt

European
Patent Office

Office européen
des brevets

# EUROPEAN SEARCH REPORT

**Application Number**

EP 25 16 6418

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | JOFFE ED - INSTITUTE OF ELECTRICAL AND ELECTRONICS ENGINEERS: "GROUND TESTING OF AN OPERATIONAL FIGHTER AIRCRAFT FOR P-STATIC DISCHARGE EFFECTS", INTERNATIONAL SYMPOSIUM ON ELECTROMAGNETIC COMPATIBILITY. SAN DIEGO, SEPT. 16 - 18, 1986; [INTERNATIONAL SYMPOSIUM ON ELECTROMAGNETIC COMPATIBILITY. COMPATIBILITY], NEW YORK, IEEE, US, 16 September 1986 (1986-09-16), pages 288-292, XP002097637, * pages 1-4 * ----- | 1-15 | |

TECHNICAL FIELDS
SEARCHED (IPC)

The present search report has been drawn up for all claims

| Place of search | Date of completion of the search | Examiner |
|---|---|---|
| Munich | 11 September 2025 | Maric, Viktor |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

........................................................................

& : member of the same patent family, corresponding document

EPO FORM 1503 03.82 (P04C01)

page 2 of 2

## ANNEX TO THE EUROPEAN SEARCH REPORT
## ON EUROPEAN PATENT APPLICATION NO.

EP 25 16 6418

This annex lists the patent family members relating to the patent documents cited in the above-mentioned European search report.
The members are as contained in the European Patent Office EDP file on
The European Patent Office is in no way liable for these particulars which are merely given for the purpose of information.

11-09-2025

| Patent document cited in search report | Publication date | Patent family member(s) | Publication date |
|---|---|---|---|
| US 2015331028 A1 | 19-11-2015 | NONE | |

EPO FORM P0459

For more details about this annex : see Official Journal of the European Patent Office, No. 12/82